# FASCICULE DE BREVET EUROPEEN

(11) **EP 3 550 621 B1**
(45) Date de publication et mention de la délivrance du brevet: **20.05.2020**
(21) Numéro de dépôt: 19165352.6
(22) Date de dépôt: 26.03.2019
(51) Int. Cl.: H01L 45/00, H01L 27/24

(54) **CIRCUIT INTÉGRÉ À TRANSISTORS À BASE COMMUNE**
INTEGRIERTER SCHALTKREIS MIT TRANSISTOREN MIT EINER GEMEINSAMEN BASIS
INTEGRATED TRANSISTOR CIRCUIT WITH COMMON BASE

(30) Priorité: 06.04.2018 FR 1853041
(43) Date de publication de la demande: 09.10.2019
(73) Titulaire: STMICROELECTRONICS (ROUSSET) SAS, 13790 Rousset (FR)
(72) Inventeur: BOIVIN, Philippe, 13770 VENELLES (FR)
(74) Mandataire: Cabinet Beaumont

(56) Documents cités:
- JP-A- 2005 026 392
- US-A1- 2012 099 363
- US-B1- 7 847 374

## Description

### Domaine

La présente demande concerne les circuits intégrés et plus particulièrement les connexions de transistors bipolaires. La présente demande s'applique plus particulièrement à la réalisation d'une matrice de points mémoire.

### Exposé de l'art antérieur

Les mémoires sont généralement sous forme de matrices, comprenant des lignes de mot ("wordline"), et des colonnes, ou ligne de bit ("bitline"). Un point mémoire contenant une information binaire se situe à chaque croisement d'une ligne de mot et d'une ligne de bit.

Dans une mémoire à changement de phase, chaque point mémoire comprend une couche de matériau à changement de phase dont la partie inférieure est en contact avec un élément résistif. Les matériaux à changement de phase sont des matériaux qui peuvent basculer d'une phase cristalline à une phase amorphe et inversement. Ce basculement est provoqué par une augmentation de la température de l'élément résistif dans lequel on fait passer un courant électrique. La différence de résistance électrique entre la phase amorphe du matériau et sa phase cristalline est utilisée pour définir deux états de mémoire, par exemple 0 et 1.

Dans l'exemple d'une mémoire à changement de phase, les points mémoire sont par exemple commandés par des transistors bipolaires qui font passer, ou non, le courant servant à chauffer les éléments résistifs. Les points mémoire appartenant à une même ligne de bit sont connectés par un conducteur recouvrant le matériau à changement de phase et les points mémoire appartenant à une même ligne de mot sont connectés ensemble par les bases des transistors bipolaires, par exemple par une base commune à tous les transistors d'une même ligne de mot. Un exemple de l'art antérieur se trouve dans le brevet JP2005/26392.

L'information binaire d'un point mémoire d'une mémoire à changement de phase est par exemple accédée en mesurant la résistance entre la ligne de bit et la ligne de mot du point mémoire.

### Résumé

Ainsi, un mode de réalisation prévoit un circuit intégré comprenant : une ligne de transistors bipolaires avec une base commune, la base commune étant située entre des premières et secondes régions constituant des bornes de conduction, les premières régions étant séparées les unes des autres par des murs d'isolant dans une première direction ; une tranchée isolante dans une seconde direction, parallèlement et en contact avec la ligne de transistors ; et un peigne en matériau conducteur contactant avec la base et étant situé dans les murs d'isolant et dans la tranchée isolante, dans lequel le peigne comprend une barre conductrice principale s'étendant dans la tranchée isolante et des barres conductrices auxiliaires s'étendant depuis la barre conductrice principale dans les murs d'isolant.

Selon un mode de réalisation, les barres conductrices ont une largeur comprise entre 25 et 45 nm.

Selon un mode de réalisation, chaque transistor commande un point mémoire.

Selon un mode de réalisation, les points mémoire sont des points mémoire d'une mémoire à changement de phase.

Selon un mode de réalisation, le peigne est connecté par un seul via à un réseau d'interconnexion.

Selon un mode de réalisation, le peigne est en métal.

Selon un mode de réalisation, la première région de chaque transistor est formée sur la base, la base étant formée sur la seconde région.

Selon un mode de réalisation, les transistors de la ligne ont une seconde région commune.

Un mode de réalisation prévoit un procédé de fabrication de transistors bipolaires comprenant les étapes suivantes : former une ligne de transistors bipolaires ayant une base commune, la base commune étant située entre des premières et secondes régions constituant des bornes de conduction, les premières régions étant séparées les unes des autres par des murs d'isolant, une tranchée isolante étant située parallèlement et en contact avec la ligne de transistors ; déposer un masque sur la couche comprenant les premières régions, le masque comprenant une ouverture en forme de peigne s'étendant en regard des tranchées isolantes et en regard des murs d'isolant ; former des cavités par gravure à travers l'ouverture jusqu'à atteindre la base entre chaque couple de premières régions ; et remplir les cavités d'un matériau conducteur.

Selon un mode de réalisation, les zones de la base commune rendues accessibles par la gravure sont dopées plus fortement que la majorité de la base.

Selon un mode de réalisation, le matériau conducteur est un métal.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, schématique, de transistors bipolaires ayant une base commune ;
la figure 2 est une vue en perspective, schématique, d'un mode de réalisation de transistors bipolaires ;
la figure 3 est une vue de dessus, schématique, du mode de réalisation de la figure 2 ; et
les figures 4A à 4C sont des vues en coupe illustrant des étapes de fabrication de la structure de la figure 2.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, seuls les transistors ont été représentés. Les points mémoire et les réseaux d'interconnexion auxquels ils peuvent être connectés ne sont pas détaillés.

Dans la description qui suit, lorsque l'on fait référence à des qualificatifs de position, tels que les termes "dessus", "dessous", "supérieur", "inférieur", etc., il est fait référence à l'orientation des éléments concernés dans les figures. Sauf précision contraire, les expressions "approximativement" et "sensiblement" signifient à 10 % près, de préférence à 5 % près.

Sauf précision contraire, lorsque l'on fait référence à deux éléments connectés entre eux, cela signifie que ces éléments sont directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments.

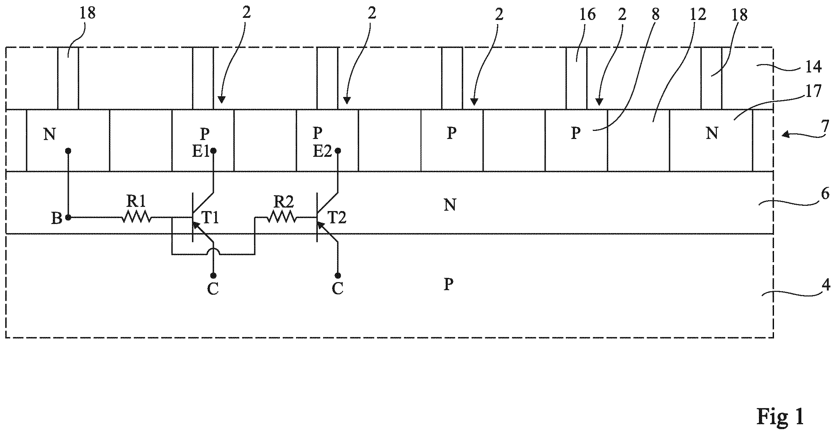

La figure 1 est une vue en coupe, schématique, d'une portion de circuit intégré comprenant quatre transistors bipolaires 2, par exemple de type PNP. Les transistors bipolaires considérés sont des transistors bipolaires verticaux, c'est-à-dire des transistors bipolaires dont les différentes parties, la base et les régions constituant les deux bornes de conduction, c'est-à-dire l'émetteur et le collecteur, sont formées les unes au-dessus des autres. On a représenté, de plus, une partie du schéma électrique équivalent.

Les transistors 2, ou T1 et T2 dans le schéma électrique équivalent, comprennent un collecteur commun 4, ou C, formé par une couche de matériau semiconducteur de type P. Les transistors 2 comprennent, de plus, une base 6, ou B, commune. La base 6 est formée par une couche de matériau semiconducteur, par exemple du silicium, de type N, recouvrant le collecteur 4. La base 6 est recouverte d'une couche 7 contenant des émetteurs 8, ou E1 et E2.

Les émetteurs 8, ou E1 et E2, sont situés sur et en contact avec la base 6. Chaque émetteur 8 est constitué par une région en matériau semiconducteur de type P, par exemple du silicium. Les émetteurs 8 sont séparés les uns des autres par des murs d'isolant 12. En figure 1, quatre émetteurs 8 sont représentés.

Une couche d'isolant 14 recouvre les émetteurs 8 et les murs 12. Des vias 16 traversent la couche d'isolant 14 jusqu'aux émetteurs 8, de manière à les relier avec des éléments non représentés. Les vias 16 relient par exemple les émetteurs 8 avec des niveaux de métallisations d'un réseau d'interconnexion. Les vias 16 peuvent aussi relier les émetteurs 8 à du matériau à changement de phase par l'intermédiaire d'éléments résistifs, de manière à former des points mémoire d'une mémoire à changement de phase commandés par les transistors bipolaires 2. Les quatre transistors 2 font alors partie d'une même ligne de mot d'une mémoire.

Des régions 17 de prise de contact de la base 6 sont régulièrement réparties. Ces régions sont constituées de matériau semiconducteur de type N sur et en contact avec la base 6 et séparées des émetteurs 8 par des murs d'isolant 12. Les régions 17 sont plus fortement dopées que la base 6. Les régions 17 sont reliées par des vias 18, similaires aux vias 16, et par un réseau d'interconnexion non représenté, à une borne de connexion externe non représentée.

Dans l'exemple de la figure 1, une région 17 est formée tous les quatre émetteurs 8. En effet, il n'est pas nécessaire d'avoir autant de régions 17 que d'émetteurs 8. Comme la surface de chaque région 17 correspond au moins à la surface d'un émetteur 8, diminuer le nombre de régions 17 permet d'augmenter le nombre de transistors dans une ligne de même longueur.

Cependant, le matériau semiconducteur de la base 6, par exemple le silicium, possède une résistance relativement élevée. Il existe donc des résistances parasites, dont deux sont représentées dans le schéma électrique équivalent et sont désignées par R1 et R2, pouvant par exemple être supérieures à 1 kΩ (kilo ohm) entre deux transistors ou entre un transistor et une région 17. Cette résistance parasite est d'autant plus élevée que les émetteurs et/ou régions sont éloignés.

On souhaite, d'une part, avoir une résistance parasite identique pour tous les transistors 2, ce qui peut être obtenu en formant une région 17 pour chaque transistor, et d'autre part, diminuer la surface nécessaire pour chaque ligne de transistors, ce qui peut être obtenu en formant une unique région 17 par ligne de transistors. Une solution est de faire un compromis en formant des régions 17 régulièrement dans chaque ligne.

Cependant, la résistance entre un émetteur 8 et la région 17 la plus proche n'est pas identique pour tous les émetteurs 8. De plus, la présence des régions 17 limite le nombre d'émetteurs 8, et donc de points mémoire, pouvant être formés sur une ligne d'une longueur donnée.

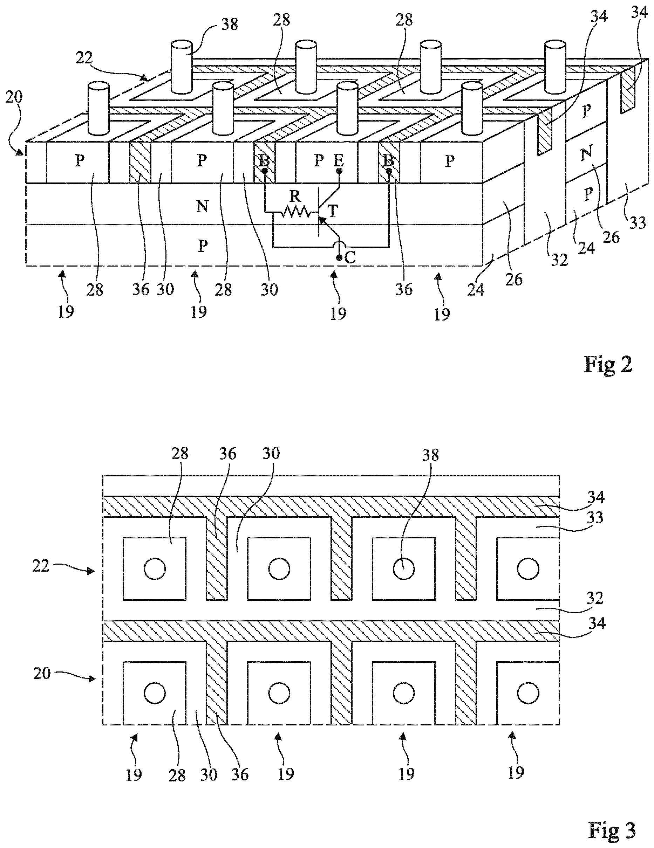

La figure 2 est une vue en perspective, schématique, d'un mode de réalisation de transistors bipolaires 19. On a aussi représenté une partie du schéma électrique équivalent représentant un transistor T et ses connexions.

La figure 3 est une vue de dessus du mode de réalisation de la figure 2.

Les figures 2 et 3 représentent une matrice de huit transistors bipolaires, séparés en deux lignes 20 et 22, comprenant chacune quatre transistors. Chaque transistor bipolaire 19 commande, par exemple, un point mémoire d'une mémoire à changement de phase. Les lignes 20 et 22 commandent alors des lignes de mot de la mémoire à changement de phase, et les colonnes de la matrice commandent des lignes de bit de la mémoire. Chaque transistor comprend une base (B) et deux régions semiconductrices constituant les bornes de conduction, émetteur (E) et collecteur (C) .

Comme cela est illustré en figure 2, chaque ligne 20 ou 22 de transistors 19 comprend une région 24 constituant un collecteur, commun à toute la ligne dans cet exemple. La région 24 est formée par une couche de matériau semiconducteur, par exemple de type P. Chaque région 24 d'une ligne 20 ou 22 est recouverte d'une base 26 commune aux transistors de cette ligne, constituée par une couche de matériau semiconducteur, par exemple de type N.

Des régions 28 en matériau semiconducteur, constituant des émetteurs et représentées en figures 2 et 3, sont formées sur et en contact avec la base 26, et sont séparées les unes des autres par des murs d'isolant 30, par exemple en oxyde de silicium, s'étendant dans une première direction. Chaque transistor 19 comprend, de plus, un via 38 traversant une couche d'isolant non représentée recouvrant les émetteurs 28. Les vias 38 permettent par exemple de connecter les transistors à des éléments résistifs non représentés d'une mémoire à changement de phase ou à un réseau d'interconnexion.

Les lignes de transistors bipolaires 19 sont séparées les unes des autres par des tranchées isolantes 32 et 33, par exemple en un oxyde usuel pour des tranchées isolantes ou STI (de l'anglais "Shallow Trench Isolation"), par exemple en oxyde de silicium, s'étendant dans une seconde direction et étant suffisamment profondes pour isoler les uns des autres les transistors 19 de lignes différentes sans pour autant traverser entièrement le substrat. Les première et seconde directions sont approximativement perpendiculaires. Les figures 2 et 3 représentent deux tranchées isolantes 32 et 33, la tranchée 32 séparant les lignes 20 et 22 et la tranchée 33 séparant la ligne 22 d'une ligne non représentée. On considère ici que chaque tranchée isolante est associée à une ligne de transistors bipolaires parallèle et en contact avec la tranchée. La tranchée 32 est ici associée à la ligne 20 et la tranchée 33 ici est associée à la ligne 22.

Une barre conductrice principale 34 s'étend dans chacune des tranchées isolantes 32 et 33. Chaque barre conductrice principale 34 est suffisamment longue pour être en regard de tous les murs d'isolant 30 séparant les émetteurs de la ligne de transistors associée à la tranchée correspondante. Des barres conductrices auxiliaires 36 s'étendent depuis chaque barre conductrice principale 34 dans les murs d'isolant 30 de la ligne associée. Chaque émetteur 28 d'une ligne donnée est donc séparé de chaque émetteur voisin par une barre conductrice auxiliaire 36. Les barres conductrices auxiliaires 36 prennent contact, ou plus généralement sont couplées, avec la base 26 commune et sont interconnectées par la barre conductrice principale 34 de manière à former un peigne. Les barres conductrices principales 34 et auxiliaires 36 sont en un matériau conducteur, de préférence en métal, par exemple du tungstène.

Chaque barre conductrice principale 34 peut être reliée à une borne de connexion extérieure non représentée par une ou plusieurs liaisons, de préférence une unique liaison pour chaque barre conductrice principale 34. Chaque liaison est faite en neutralisant un emplacement de transistor, c'est-à-dire que, bien qu'un transistor soit formé à cet emplacement, il n'est connecté à rien. Un via est ensuite formé à chacun de ces emplacements de manière à relier la barre conductrice à une borne de connexion extérieure par l'intermédiaire du réseau d'interconnexion.

Chaque émetteur 28 est séparé d'une barre conductrice auxiliaire 36, c'est-à-dire d'une prise de contact avec la base, par une distance inférieure à la largeur d'un mur d'isolant 30. La résistance parasite, désignée par R dans le schéma électrique équivalent et formée dans la base, est donc identique pour tous les transistors bipolaires 19 et est plus faible que dans l'exemple de la figure 1. Les barres conductrices principales 34 et auxiliaires 36 étant conductrices, elles forment des résistances négligeables. En particulier, les résistances parasites formées par les barres conductrices principales 34 et auxiliaires 36 sont plus faibles que celles formées dans la base entre les émetteurs 8 de la figure 1, par exemple vingt fois plus faible.

La largeur des murs d'isolant 30 dépend de la résolution des masques utilisés lors des étapes de lithophotographie du procédé de fabrication des transistors bipolaires. Avec les technologies de lithophotographie actuelles, la largeur minimale de tranchées pouvant être fabriquées est d'approximativement 100 nm.

Pour les valeurs de tension utilisées dans les mémoires, par exemple un maximum de 4 V, on considère que l'épaisseur d'oxyde de silicium minimale pour une isolation correcte entre deux éléments conducteurs, c'est-à-dire par exemple les émetteurs 28 et les barres conductrices 34 et 36, est d'approximativement 10 nm.

Il est donc possible de former des barres conductrices 34 et 36, dont la largeur est par exemple comprise entre 25 et 40 nm, dans les murs d'isolant 30 et dans les tranchées isolantes 32 et de conserver une épaisseur de 10 nm permettant une isolation considérée comme correcte entre les émetteurs 28 et les barres conductrices 34 et 36.

De manière plus générale, la largeur des barres conductrices 34 et 36 est choisie en fonction de la largeur des murs d'isolant 30 et des tranchées isolantes 32 et de la tension qu'elles devront pouvoir isoler.

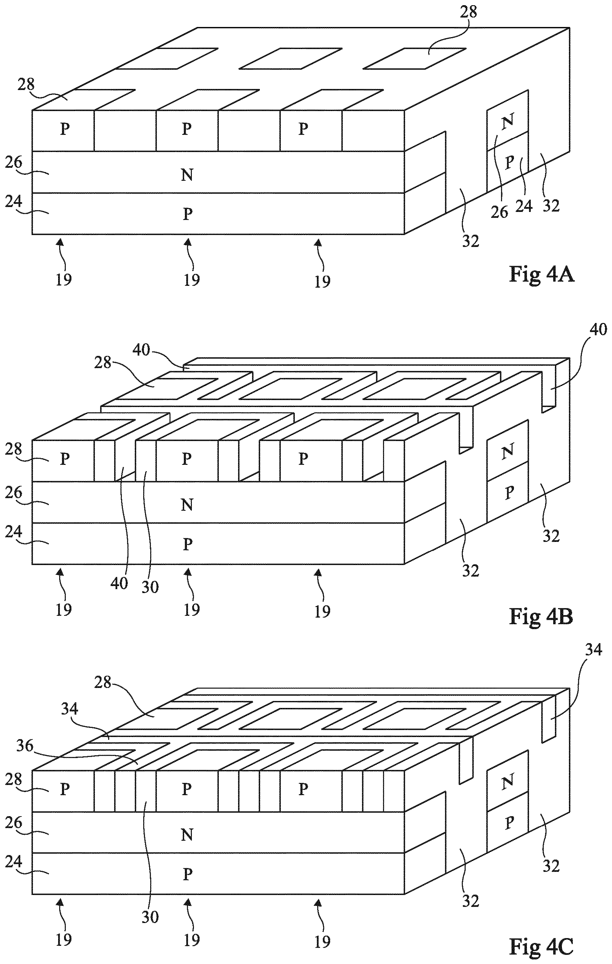

Les figures 4A à 4C illustrent un procédé de fabrication de la structure représentée en figure 2.

La figure 4A illustre une étape au cours de laquelle les transistors 19, c'est-à-dire les collecteurs, bases et émetteurs, sont d'abord formés dans un substrat. Cette étape comprend la formation et le dopage des couches constituant les collecteurs 24, les bases 26 et les émetteurs 28, la formation des tranchées 32 séparant les lignes de transistors et la formation des murs d'isolant 30 séparant les émetteurs 28. Ces étapes sont par exemple effectuées par des procédés usuels de fabrication. Les transistors sont par exemple formés de manière à être les plus proches possible pour les technologies existantes. La distance entre deux émetteurs est par exemple comprise entre 80 et 150 nm.

La figure 4B illustre une étape de fabrication au cours de laquelle un masque, non représenté, est déposé sur la couche comprenant les émetteurs. Le masque comprend des ouvertures ayant la forme des barres conductrices principales 34 et auxiliaires 36 situées respectivement au-dessus des tranchées isolantes 32 et des murs d'isolant 30 de telle manière que les ouvertures ne soient pas, même partiellement, en regard des émetteurs 28.

Une gravure est effectuée de manière à graver des cavités 40 à travers les ouvertures du masque jusqu'à atteindre, entre les émetteurs 28, les bases 26 de chaque ligne de transistors. La gravure est effectuée simultanément pour les barres conductrices principales 34 et les barres conductrices auxiliaires 36 qui ont donc approximativement la même profondeur.

Les zones des bases 26 rendues accessibles par les cavités peuvent éventuellement être re-dopées de manière à permettre une meilleure connexion électrique entre les bases 26 et les barres conductrices auxiliaires 36. Ces zones sont donc plus fortement dopées que la majorité de chaque base 26.

La figure 4C illustre une étape de fabrication au cours de laquelle les cavités sont remplies de matériau conducteur, de préférence un métal, par exemple le tungstène.

Au cours d'une étape postérieure non illustrée, une couche d'isolant est ensuite déposée sur la structure et des vias sont formés. Les vias formés comprennent les vias 38 connectés aux émetteurs 28 des transistors ainsi que les vias connectés aux barres conductrices principales 34 à l'emplacement des lignes de bit neutralisées et éventuellement d'autres vias du même niveau.

A titre de variante, pour d'autres applications où certains transistors sont intégralement en parallèle, une barre conductrice principale 34, située dans une tranchée isolante séparant des lignes de transistors, peut interconnecter des barres conductrices auxiliaires 36 situées entre des émetteurs de deux lignes de transistors.

Un avantage des modes de réalisation décrits est que les résistances parasites entre les prises de contact de base et les différents émetteurs sont plus faibles que dans les réalisations usuelles et sont sensiblement identiques pour tous les transistors.

Un autre avantage des modes de réalisation décrits est que l'interconnexion des prises de contact avec la base, c'est-à-dire des barres conductrices auxiliaires 36, n'est pas faite à travers le réseau d'interconnexion. Il n'est donc pas nécessaire de prévoir l'espace suffisant pour une métallisation entre les métallisations du niveau inférieur du réseau d'interconnexion reliées à deux émetteurs voisins. Ainsi, la distance entre deux émetteurs ne dépend que de la résolution des masques utilisés lors de la fabrication, de l'épaisseur d'isolant permettant d'isoler correctement les tensions prévues et de l'épaisseur des barres conductrices.

Un autre avantage des modes de réalisation décrits est une augmentation de la densité de transistors et donc de points mémoire. Dans le cas où chaque ligne de mot comprend une unique connexion au réseau d'interconnexion, la longueur d'une ligne telle que celle décrite en relation avec les figures 2 et 3 est diminuée d'approximativement 35 % par rapport à une structure du type de celle de la figure 1 ayant le même nombre de transistors.

Des modes de réalisation particuliers ont été décrits. Diverses variantes et modifications apparaîtront à l'homme de l'art. En particulier, les transistors bipolaires décrits en relation avec les figures sont des transistors bipolaires PNP. Il peut cependant s'agir de transistors bipolaires NPN.

De plus, les transistors décrits dans la présente demande l'ont été dans le cadre de transistors commandant des points mémoire, et plus particulièrement des mémoires à changement de phase. Cependant, les modes de réalisation décrits peuvent aussi être mis en oeuvre pour des lignes de transistors ayant une base commune utilisées dans d'autres domaines.

Dans les modes de réalisation décrits, les barres conductrices sont par exemple en métal. Les barres conductrices peuvent aussi être en silicium polycristallin. Eventuellement, les barres conductrices peuvent être séparées de la couche 26 et des murs isolants 30 par une couche de métal, par exemple du titane.

La présence de barres conductrices principales et auxiliaires en silicium polycristallin permet d'augmenter la densité de silicium polycristallin par rapport à la densité de silicium polycristallin dans la structure de la figure 1 ou par rapport à une structure similaire à la structure des figures 2 et 3 dans laquelle les barres 34 et 36 sont en métal. Cela permet notamment d'obtenir une structure ayant un stress thermique inférieur à celui d'une structure similaire à la structure des figures 2 et 3 dans laquelle les barres 34 et 36 seraient en métal.

## Revendications

1. Circuit intégré comprenant :
une ligne (20, 22) de transistors bipolaires (19) avec une base commune (26), la base commune étant située entre des premières (28) et secondes régions (24) constituant des bornes de conduction, les premières régions étant séparées les unes des autres par des murs d'isolant (30) dans une première direction ;
une tranchée isolante (32) dans une seconde direction, parallèlement et en contact avec la ligne de transistors ; et
un peigne (34, 36) en matériau conducteur couplé avec la base et étant situé dans les murs d'isolant et dans la tranchée isolante,
dans lequel le peigne (34, 36) comprend une barre conductrice principale (34) s'étendant dans la tranchée isolante (32) et des barres conductrices auxiliaires (36) s'étendant depuis la barre conductrice principale (34) dans les murs d'isolant (30).

2. Circuit intégré selon la revendication 1, dans lequel les barres conductrices (34, 36) ont une largeur comprise entre 25 et 45 nm.

3. Circuit intégré selon la revendication 1 ou 2, dans lequel chaque transistor (19) commande un point mémoire.

4. Circuit intégré selon la revendication 3, dans lequel les points mémoire sont des points mémoire d'une mémoire à changement de phase.

5. Circuit intégré selon l'une quelconque des revendications 1 à 4, dans lequel le peigne (34, 36) est couplé par un seul via à un réseau d'interconnexion.

6. Circuit intégré selon l'une quelconque des revendications 1 à 5, dans lequel le peigne (34, 36) est en métal.

7. Circuit intégré selon l'une quelconque des revendications 1 à 5, dans lequel le peigne (34, 36) est en silicium polycristallin.

8. Circuit intégré selon l'une quelconque des revendications 1 à 7, dans lequel la première région (28) de chaque transistor est formée sur la base (26), la base étant formée sur la seconde région (24).

9. Circuit intégré selon l'une quelconque des revendications 1 à 8, dans lequel les transistors (19) de la ligne ont une seconde région (24) commune.

10. Procédé de fabrication de transistors bipolaires (19) comprenant les étapes suivantes :
former une ligne de transistors bipolaires ayant une base (26) commune, la base commune étant située entre des premières (28) et secondes (24) régions constituant des bornes de conduction, les premières régions étant séparées les unes des autres par des murs d'isolant (30), une tranchée isolante (32) étant située parallèlement et en contact avec la ligne de transistors (19) ;
déposer un masque sur la couche comprenant les premières régions (28), le masque comprenant une ouverture en forme de peigne (34, 36) s'étendant en regard des tranchées isolantes (32) et en regard des murs d'isolant (30) ;
former des cavités par gravure à travers l'ouverture jusqu'à atteindre la base (26) entre chaque couple de premières régions ; et
remplir les cavités d'un matériau conducteur.

11. Procédé de fabrication selon la revendication 10, dans lequel les zones de la base (26) commune rendues accessibles par la gravure sont dopées plus fortement que la majorité de la base.

12. Procédé de fabrication selon la revendication 10 ou 11, dans lequel le matériau conducteur est un métal.

## Patentansprüche

1. Integrierte Schaltung, die Folgendes aufweist:
eine Reihe (20, 22) von bipolaren Transistoren (19) mit einer gemeinsamen Basis (26), wobei die gemeinsame Basis zwischen ersten Bereichen (28) und zweiten Bereichen (24) liegt, die Leitungsanschlüsse bilden, wobei die ersten Bereiche durch Wände eines Isolators (30) in einer ersten Richtung voneinander getrennt sind;
einen Isoliergraben (32) in einer zweiten Richtung, parallel zu und in Kontakt mit der Transistorreihe; und
einen Kamm (34, 36) aus einem leitenden Material, der mit der Basis verbunden ist und sich in den Isolatorwänden und im Isoliergraben befindet,
wobei der Kamm (34, 36) einen Hauptleiterstab (34), der sich in dem Isoliergraben (32) erstreckt, und Hilfsleiterstäbe (36), die sich von dem Hauptleiterstab (34) in die Isolatorwände (30) erstrecken, aufweist.

2. Integrierte Schaltung nach Anspruch 1, wobei die Leiterstäbe (34, 36) eine Breite im Bereich von 25 bis 45 nm haben.

3. Integrierte Schaltung nach Anspruch 1 oder 2, wobei jeder Transistor (19) eine Speicherzelle steuert.

4. Integrierte Schaltung nach Anspruch 3, wobei die Speicherzellen Speicherzellen eines Phasenwechselspeichers sind.

5. Integrierte Schaltung nach einem der Ansprüche 1 bis 4, wobei der Kamm (34, 36) über ein einziges Via an ein Verbindungsnetzwerk gekoppelt ist.

6. Integrierte Schaltung nach einem der Ansprüche 1 bis 5, wobei der Kamm (34, 36) aus Metall hergestellt ist.

7. Integrierte Schaltung nach einem der Ansprüche 1 bis 5, wobei der Kamm (34, 36) aus Polysilizium hergestellt ist.

8. Integrierte Schaltung nach einem der Ansprüche 1 bis 7, wobei der erste Bereich (28) jedes Transistors auf der Basis (26) ausgebildet ist, wobei die Basis auf dem zweiten Bereich (24) ausgebildet ist.

9. Integrierte Schaltung nach einem der Ansprüche 1 bis 8, wobei die Transistoren (19) der Reihe einen gemeinsamen zweiten Bereich (24) haben.

10. Ein Verfahren zur Herstellung von bipolaren Transistoren (19), das die folgenden Schritte aufweist:
Ausbilden einer Reihe von bipolaren Transistoren mit einer gemeinsamen Basis (26), wobei die gemeinsame Basis zwischen ersten (28) und zweiten (24) Bereichen, die Leitungsanschlüsse bilden, angeordnet ist, wobei die ersten Bereiche durch Wände eines Isolators (30) voneinander getrennt sind, wobei ein Isoliergraben (32) parallel zu und in Kontakt mit der Reihe von Transistoren (19) angeordnet ist;
Abscheiden einer Maske auf der Schicht, die die ersten Bereiche (28) aufweist, wobei die Maske eine kammförmige Öffnung (34, 36) aufweist, die sich gegenüber den isolierenden Gräben (32) und gegenüber den Isolatorwänden (30) erstreckt;
Ausbilden von Hohlräumen durch Ätzen durch die Öffnung, um die Basis (26) zwischen jedem Paar erster Bereiche zu erreichen; und
Füllen der Hohlräume mit einem leitfähigen Material.

11. Herstellungsverfahren nach Anspruch 10, wobei die durch das Ätzen zugänglich gemachten Bereiche der gemeinsamen Basis (26) stärker dotiert sind als der Großteil der Basis.

12. Das Herstellungsverfahren nach Anspruch 10 oder 11, wobei das leitende Material ein Metall ist.

## Claims

1. An integrated circuit comprising:
a row (20, 22) of bipolar transistors (19) having a common base (26), the common base being located between first (28) and second regions (24) forming conduction terminals, the first regions being separated from one another by walls of insulator (30) in a first direction;
an insulating trench (32) in a second direction, parallel to and in contact with the transistor row; and
a comb (34, 36) of a conductive material coupled to the base and being located in the insulator walls and in the insulating trench,
wherein the comb (34, 36) comprises a main conductive bar (34) extending in the insulating trench (32) and auxiliary conductive bars (36) extending from the main conductive bar (34) into the insulator walls (30).

2. The integrated circuit of claim 1, wherein the conductive bars (34, 36) have a width in the range from 25 to 45 nm.

3. The integrated circuit of claim 1 or 2, wherein each transistor (19) controls a memory cell.

4. The integrated circuit of claim 3, wherein the memory cells are memory cells of a phase-change memory.

5. The integrated circuit of any of claims 1 to 4, wherein the comb (34, 36) is coupled by single via to an interconnection network.

6. The method of any of claims 1 to 5, wherein the comb (34, 36) is made of metal.

7. The method of any of claims 1 to 5, wherein the comb (34, 36) is made of polysilicon.

8. The integrated circuit of any of claims 1 to 7, wherein the first region (28) of each transistor is formed on the base (26), the base being formed on the second region (24).

9. The integrated circuit of any of claims 1 to 8, wherein the transistors (19) of the row have a common second region (24).

10. A method of manufacturing bipolar transistors (19), comprising the steps of:
forming a row of bipolar transistors having a common base (26), the common base being located between first (28) and second (24) regions forming conduction terminals, the first regions being separated from one another by walls of insulator (30), an insulating trench (32) being located parallel to and in contact with the row of transistors (19);
depositing a mask on the layer comprising the first regions (28), the mask comprising a comb-shaped opening (34, 36) extending opposite the insulating trenches (32) and opposite the insulator walls (30);
forming cavities by etching through the opening to reach the base (26) between each pair of first regions; and
filling the cavities with a conductive material.

11. The manufacturing method of claim 10, wherein the areas of the common base (26) made accessible by the etching are more heavily doped than most of the base.

12. The manufacturing method of claim 10 or 11, wherein the conductive material is a metal.
